(19) **Europäisches Patentamt**

**European Patent Office**

**Office européen des brevets**

(11) **EP 0 603 549 B1**

(12) **EUROPÄISCHE PATENTSCHRIFT**

(45) Veröffentlichungstag und Bekanntmachung des Hinweises auf die Patenterteilung:
**29.03.2000 Patentblatt 2000/13**

(51) Int. Cl.$^7$: **G02B 6/42**

(21) Anmeldenummer: **93118642.3**

(22) Anmeldetag: **19.11.1993**

(54) **Optische Vorrichtung**

Optical device

Dispositif optique

(84) Benannte Vertragsstaaten:
**DE DK ES FR GB GR IT NL PT SE**

(30) Priorität: **24.04.1993 DE 4313487**
**25.11.1992 DE 9217928 U**

(43) Veröffentlichungstag der Anmeldung:
**29.06.1994 Patentblatt 1994/26**

(73) Patentinhaber: **ROBERT BOSCH GMBH**
**70442 Stuttgart (DE)**

(72) Erfinder:
• **Schwaderer, Bernhard, Dr.-Ing.**
**D-71554 Weissach i.T. (DE)**
• **Hauer, Heiner, Dipl.-Ing.**
**D-70734 Fellbach (DE)**
• **Kuke, Albrecht, Dr. rer. nat.**
**D-71549 Auenwald (DE)**

(56) Entgegenhaltungen:
**EP-A- 0 192 850** **EP-A- 0 331 331**
**EP-A- 0 420 029** **WO-A-87/04566**
**DE-A- 3 833 413** **DE-C- 3 914 835**
**US-A- 5 017 986**

• **PATENT ABSTRACTS OF JAPAN vol. 10, no. 308 (P-508) 21. Oktober 1986 & JP-A-61 121 014 (NEC CORP) 9. Juni 1986**

**Beschreibung**

Die Erfindung betrifft eine optische Vorrichtung nach dem Oberbegriff des Patentanspruches 1. Eine solche Vorrichtung ist aus der US-A-5,017,986 bekannt.

Aus der JP-A-61/121014 ist eine optische Vorrichtung bekannt, die ein lichtaussendenden Element mit einem lichtempfangenden Element mit Hilfe eines Lichtbündels verbindet. Diese bekannte Vorrichtung weist folgende Merkmale auf:

a) das lichtaussende bzw. -empfangende Element befindet sich auf einer Seite eines lichtdurchlässigen Trägers,

b) der Träger trägt auf der anderen Seite einen Lichtwellenleiterabschnitt und zwei Reflexionsflächen,

c) der Verlauf des Lichtbündels geht vom lichtsendenden Element aus, trifft auf eine Reflexionsfläche, läuft durch den Lichtwellenleiterabschnitt, trifft auf die zweite Reflexionsfläche, und endet am lichtempfangenden Element.

Aus der DE 39 14 835 ist eine Anordnung zur Ankopplung eines Lichtwellenleiters an ein optisches Sende- oder Empfangselement bekannt. Der Lichtwellenleiter und das optische Sende- bzw. Empfangselement sind auf verschiedenen Trägern fixiert, die verschiebbar aufeinanderliegen. Das Lichtbündel gelangt durch zweimalige Spiegelung an je einer auf einem Träger befindlichen Spiegelebene vom Lichtwellenleiter zum optisch aktiven Element. Durch Verschieben der Träger wird eine Justierung erreicht.

In der deutschen Patentanmeldung P 43 01 455 ist vorgeschlagen, einen einteiligen Träger aus einkristallinem Silizium zu verwenden, auf dessen Unterseite mindestens ein Lichtwellenleiterende in einer Nut fixiert ist und auf dessen Oberseite mindestens ein Sende- oder Empfangselement vorgesehen ist, dessen lichtempfindliche bzw. aussendende Fläche der Unterseite zugewandt ist. Der Lichtwellenleiter ist dabei in der V-Nut befestigt. Das Licht gelangt vom Lichtwellenleiter durch den Träger zum Empfangselement (bzw. vom Sendeelement durch den Träger zum Lichtwellenleiter), wobei es an einer Fläche totalreflektiert wird.

Es ist Aufgabe der Erfindung eine Anordnung anzugeben, mit der mindestens ein lichtaussendendes mit mindestens einem lichtempfangenden Element, insbesondere wahlweise, verbunden werden kann.

Die Aufgabe wird mit einer optischen Vorrichtung mit den Merkmalen des Patentanspruches 1 gelöst. Vorteilhafte Weiterbildungen sind den Unteransprüchen zu entnehmen.

Als lichtaussendende bzw. -empfangende Elemente können sowohl optoelektronische Sende- bzw. Empfangselemente, aber auch lichtausstrahlende Lichtwellenleiter bzw. Lichtwellenleiter, in die Licht eingestrahlt wird, eingesetzt sein. Somit sind auch rein optische Anordnungen denkbar. Bei dem Einsatz optoelektronischer Elemente, können neben diesen Elementen auch Zuleitungen und elektronische Schaltungen z.B. zur Ansteuerung auf der Oberfläche eines Trägers vorgesehen sein.

Es wird ein modulares Montagekonzept zur Verbindung einer Vielzahl von optischen Sendeelementen mit einer Vielzahl von optischen Empfangselementen unter Einschluß von optischen Verteilebenen zwischen diesen elektrooptischen Elementen und von elektrischen Verdrahtungs- und Montageebenen für die elektrooptischen Elemente sowie für Elektronikebenen für die Treiber- und Signalverarbeitungsschaltungen vorgeschlagen. Solch eine optoelektronische Verknüpfung ist beispielsweise für den Einsatz in Cross-Connect-Systemen, für optische Vermittlungstechnik oder in neuralen Netzen erforderlich. Nach dem Stand der Technik werden hierzu Einzelkomponenten über Fasern miteinander verbunden. Angestrebt wird die Verknüpfung von räumlich voneinander getrennten Arrays von Sende- und Empfangselementen über Freistrahloptiken mit Strahlführung über Hologramme. Solche Systeme konnten aber wegen der damit verbundenen technologischen Schwierigkeiten noch nicht realisiert werden.

Die angegebene optische Vorrichtung macht Gebrauch von einigen vorteilhaften Eigenschaften des Siliziums. Silizium ist durch anisotrope Ätzung mikromechanisch strukturierbar, es besitzt eine hohe Wärmeleitfähigkeit und ist für IR-Licht ab 1200 nm Wellenlänge gut transparent. Aufgrund dieser Eigenschaften bietet Silizium die ideale Montageplattform zur Aufnahme von Fasern, Streifenwellenleitern, optischen Sende- und Empfangselementen und optischen Abbildungssystemen. Wegen der Transparenz des Siliziums kann dabei der Lichtweg durch das Substrat geführt werden, so daß die Aufnahmeebenen für die Sende-, Empfangs- und Lichtverteilelemente sowie die elektronischen Schaltebenen auf verschiedenen Seiten von übereinander gestapelten Siliziumsubstraten angebracht werden können.

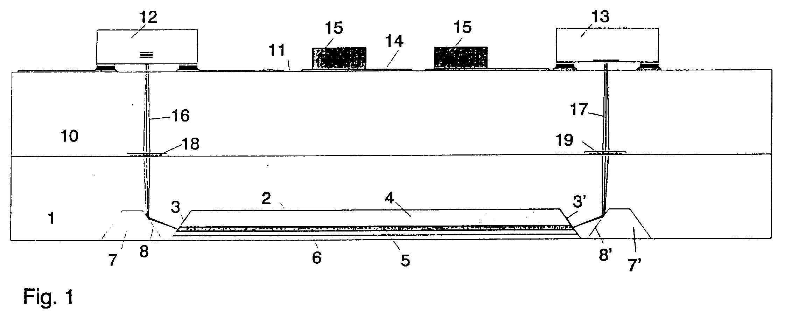

Ein erfindungsgemäßes Ausführungsbeispiel wird anhand von Figur 1 erläutert. Ein erster Siliziumträger 1, dessen (100)-Ebene in der Waferebene liegt, hat auf seiner Unterseite eine anisotrop geätzte Vertiefung 2 mit rechteckförmigem Grundriß, ebenem Boden und schrägen Seitenflächen 3 und 3', die durch (111)-Ebenen gebildet werden. Der ebene Boden wird durch zeitliche Begrenzung der Tiefenätzung oder durch eine Ätzstoppschicht als (100)-Ebene gebildet. Die Seitenflächen 3 und 3' schließen wegen der kristallografischen Eigenschaften des Siliziums einen Böschungswinkel von

$$\alpha = \arctan(\sqrt{2}) = 54{,}74°$$

mit der Waferoberfläche ein. Die Vertiefung 2 ist mit einem lichtleitenden Material 4 bis zu einer Tiefe t unterhalb der Waferoberfläche ausgefüllt. Dieses lichtleitende Material 4 reicht bis an die schrägen Böschungsränder 3 und 3' der Vertiefung 2. Hierfür wird ein Stoff gewählt, der sich gut in die Vertiefung 2 einbringen läßt und in welchem durch geeignete Prozesse Streifenwellenleiter 5 erzeugt werden können. Beispielsweise läßt sich hierfür PMMA (Plexiglas) oder ORMOCERE (organisch modifizierbare Keramik) einsetzen. Bei beiden Materialien ist bekannt, daß sich bei ihnen nach Hinzufügen von Photoinitiatoren durch Belichtung mit UV-Licht der Brechungsindex erhöhen läßt. Auf diese Weise lassen sich durch geeignete Maskierung und ganzflächige Beleuchtung oder durch Laser-Schreibprozesse ohne Maskierung Streifenwellenleiter mit höherem Brechungsindex als der ihrer Umgebung herstellen. Bei PMMA ist eine Erhöhung des Brechungsindexes nach dem Stand der Technik auch ohne Zusatz von Photoinitiatoren nur durch UV-Belichtung möglich. Erfindungsgemäß müssen die so erzeugten Streifenwellenleiter unter dem Rand der Vertiefung 2 liegen. Beim Auffüllen der Vertiefung 2 mit dem zunächst flüssigen Wellenleitermaterial beispielsweise durch Gießen oder Schleudern wird zunächst die Vertiefung 2 mindestens bis zum Rand aufgefüllt werden. Durch Planarisieren kann erreicht werden, daß die Auffüllung gerade bis zur Waferoberfläche reicht. In diesem Zustand können bereits die Wellenleiter durch die oben genannten Verfahren erzeugt werden, da durch die Belichtung die Wellenleiter innerhalb des Materials erzeugt werden. Der Kern des Wellenleiters wird dann gerade mit der oberen Kante der Randflächen der Vertiefung 2 abschließen. Sicherer ist es, den Wellenleiter etwas tiefer in die Vertiefung 2 zu legen damit durch eventuelle Unschärfen im Rand der Böschungsflächen 3 und 3' keine Streuverluste auftreten. Hierzu wird das Material 4 an seiner Oberfläche vor Erzeugen der Wellenleiter bis zu einer Tiefe von einigen µm abgetragen. Dies kann beispielsweise durch Naßätzen, Trockenätzen oder Laserablation geschehen. Nach Erzeugen der Wellenleiter kann eine Mantelschicht 6 mit geringerem Brechungsindex als der Brechungsindex der Wellenleiter aufgebracht werden um die Lichtführung zu verbessern. Die Wellenleiter 5 können in der Ebene dem gewünschten Einsatzfall entsprechend als Verzweiger, Strahlteiler, Koppler, elektrooptische Schalter usw strukturiert werden, um verschiedene Lichtpfade in der gewünschten Weise miteinander zu kombinieren.

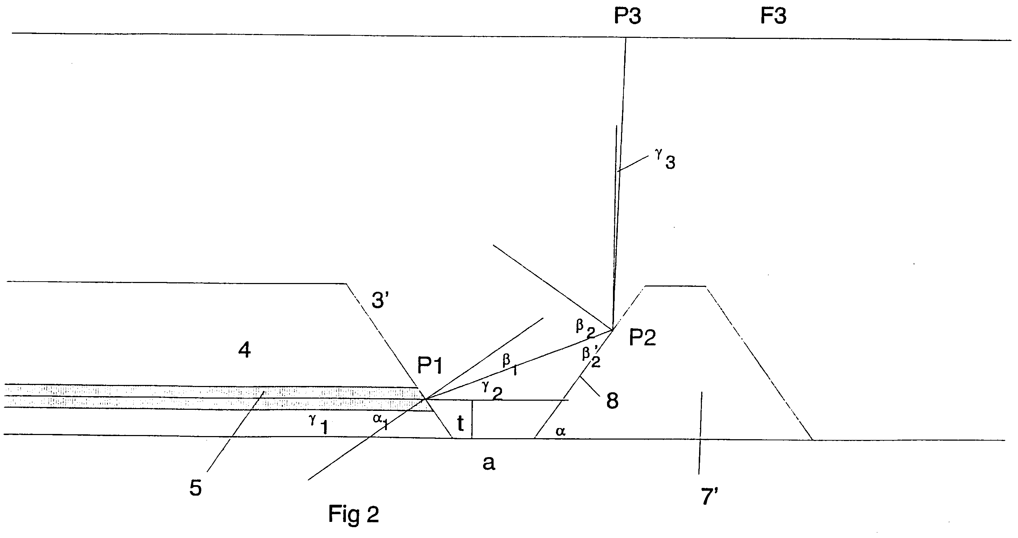

An den Wellenleiterenden, also den Ein- und Ausgängen der Wellenleiter 5 wird das Licht an den Grenzflächen 3 und 3' schräg nach oben in das Siliziumsubstrat hineingebrochen. Die Winkel sind in einem vergrößerten Ausschnitt in Figur 2 dargestellt. Der Brechungswinkel im Silizium errechnet sich nach dem Snellius'schen Brechungsgesetz mit dem Einfallswinkel von

$$\alpha 1 = 90 - \alpha = 35{,}26°$$

zu

$$\beta 1 = \arcsin((n_f/n_{si})*\sin(\alpha 1))$$

wobei $n_f$ der Brechungsindex des Streifenwellenleiters und nSi der Brechungsindex von Silizium ist. Nimmt man $n_f$ für PMMA mit 1,5 und $n_{Si}$ mit 3,4777 für eine Wellenlänge von 1,55 µm an, so ergibt sich für β1 = 14,420°.

Zur Berechnung der Strahlaufweitung nach Austritt aus der Lichtführung durch den Wellenleiter müssen auch die Randstrahlen des austretenden Lichtbündels verfolgt werden. Zur Rechnung wird ein Wellenleiter angenommen, der beim Übergang in Luft eine NA von 0,1 hätte und damit einer Standard-Einmodenfaser angepaßt wäre. Die Strahltaille hat dann einen Radius von

$$w_o = /(\pi*\tan(\Theta_L))$$

wobei

$$\Theta_L = \arcsin(NA) = 5{,}74°$$

der Divergenzwinkel des Strahls in Luft wäre. Damit erhält man aus (4) $w_o$ = 4,91 µm.

Hier tritt jedoch der Strahl nicht in Luft aus sondern in Silizium mit einem höheren Brechungsindex. Der Divergenzwinkel in Silizium ist

$$\theta_{Si} = \arctan(\ /\pi*w_o*n_{Si})) = 1{,}655°$$

Nach Brechung an der Grenzfläche 3 hat der Zentralstrahl des Bündels den Richtungswinkel gegenüber der Waferoberfläche von

$$\tau_2 = 90° - \alpha - \beta_1 = 20{,}845°$$

Für die Richtungswinkel des oberen und unteren Randstrahls ergibt sich durch Addition bzw Subtraktion von $\Theta_{Si}$

$$\tau_{2ob} = \tau_2 + \theta_{Si} = 22{,}50°$$

$$\tau_{2un} = \tau_2 - \theta_{Si} = 19{,}19°$$

In geringer Entfernung vor und hinter der Vertiefung 2 sind zwei weitere Vertiefungen 7 und 7' durch anisotropes Ätzen hergestellt. Das Lichtbündel trifft auf deren Böschungsflächen 8 bzw 8' und wird dort total reflektiert. Danach verläuft das Lichtbündel nahezu senkrecht nach oben. Die Richtungswinkel errechnen sich aus den zuvor berechneten Richtungswinkeln $\tau_{2un}$, $\tau_2$ und $\tau_{2ob}$ zu

$$\tau_{3un} = 90° - 2*\alpha + \tau_{2un} = -0{,}281°$$

$$\tau_3 = 90° - 2*\alpha + \tau_2 = 1{,}347°$$

$$\tau_{3ob} = 90° - 2*\alpha + \tau_{2ob} = 3{,}029°$$

gegenüber der Flächennormalen der Waferoberseite. Wegen der geringen Divergenz des Strahls im Silizium hat der Strahl nach Durchdringen eines 525 µm dicken Wafers auf der Waferoberseite nur eine Aufweitung von 31 µm. Bei dieser geringen Strahlaufweitung könnte beispielsweise eine Fotodiode ohne Einkoppeloptik direkt auf die Waferoberfläche von Substrat 1 gesetzt werden. In Figur 1 ist statt dessen oberhalb des Substrates 1 ein zweites Substrat 10 angebracht, das auf seiner Oberfläche 11 einen oberflächenemittierenden Laser (SELD) und eine Photodiode 13 trägt. Außerdem trägt die Ebene 11 des Substrates 10 die elektrischen Leiterbahnen 14 sowie die erforderlichen elektronischen Bauelemente 15 zur Ansteuerung und Signalauswertung der elektrooptischen Bauelemente.

Zwischen den beiden Substraten 1 und 10 sind zur Fokussierung der nahezu senkrecht durch die Substrate verlaufenden Strahlen 16 und 17 zwei Abbildungselemente 18 und 19 angebracht. Vorzugsweise können hier planar aufgebrachte Fresnellinsen eingesetzt werden. Die Übergangsstellen der Strahlen von den Substraten in Luft bzw in den Wellenleiter 5 werden mit Antireflexionsschichten versehen, um Reflexionsverluste zu vermeiden.

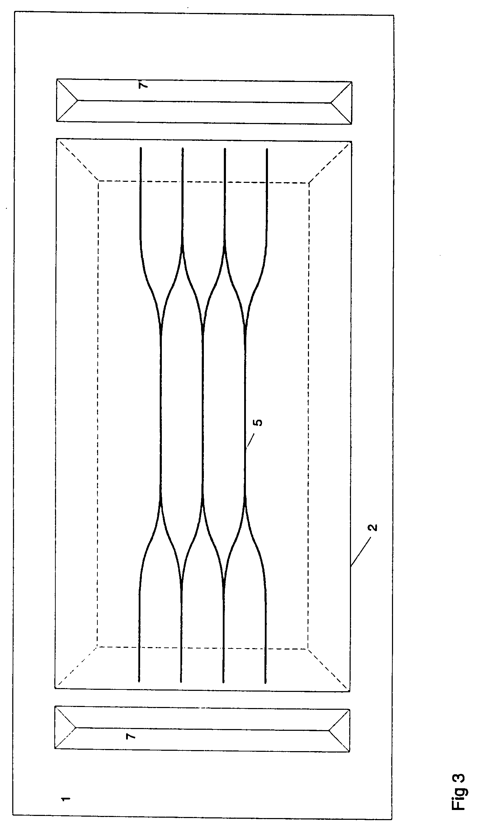

Die Figur 3 zeigt die Ansicht des Substrates 1 von unten mit Blick auf die Wellenleiterstruktur 5. Hier ist beispielhaft eine Verzweigerstruktur von Streifenwellenleitern zwischen einer Eingangsseite und einer Ausgangsseite dargestellt. Ebenso können andere Wellenleiterstrukturen wie Koppler, Sternkoppler oder aktive Schaltelemente verwirklicht werden.

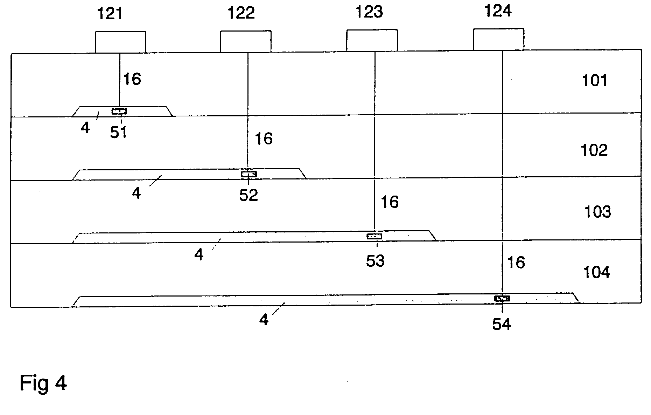

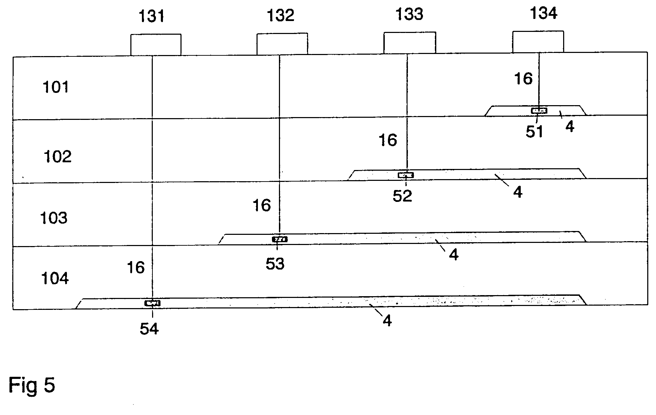

Neben der Verteilung der Signalpfade in der Ebene, wie in Figur 3 gezeigt, läßt sich mit der Stapeltechnik, also dem aufeinanderstapeln mehrerer Träger auch eine Verteilung der Signalpfade in verschiedenen Ebenen verwirklichen. Ein Ausführungsbeispiel hierfür ist in Figur 4 dargestellt. Hier sind 4 Si-Substrate 101, 102, 103 und 104 übereinander gestapelt. Die Ansicht ist hier von der Stirnseite her auf einen Schnitt durch die Randflächen der jeweiligen Vertiefungen 3, die mit dem Wellenleitermaterial 4 gefüllt sind, und jeweils optische Verzweigungsnetzwerke 51, 52, 53, 54 tragen. Die senkrecht durch die Substrate verlaufenden Strahlbündel 16 sind schematisch als Linien dargestellt. Die Wellenleiterstrukturen reichen in den jeweiligen Substraten unterschiedlich weit nach vorn, so daß die Strahlen von den vier Sendern 121, 122, 123 und 124 zu den einzelnen optischen Verteilebenen gerichtet werden können. Ebenso reichen die optischen Verteilebenen 51 bis 54 unterschiedlich weit nach hinten, so daß jeweils eine Empfangsdiode 131, 132, 133 und 134 mit einer Verteilebene 51 bis 54 verbunden ist (siehe Figur 5). Die Verbindung beliebiger Verteilebenen untereinander läßt sich in den einzelnen optischen Verteilebenen durch Umschalten auf die mit den gewünschten Ebenen verbundenen Lichtpfade erreichen. Auf diese Weise läßt sich jeder der Eingänge 121 bis 124 mit jedem der Ausgänge 131 bis 134 wahlfrei verbinden.

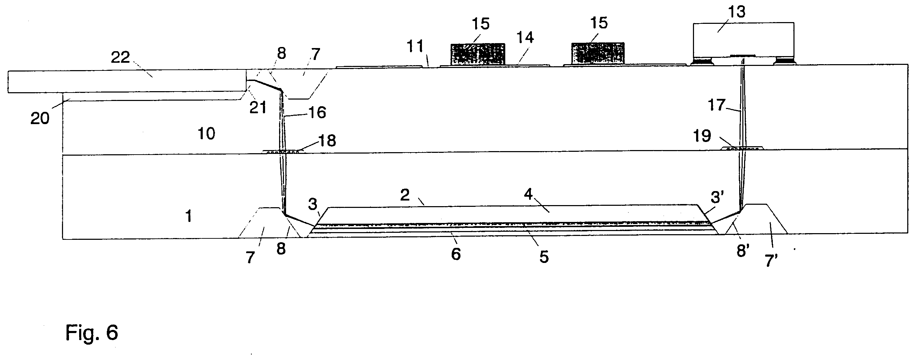

Anstelle der aktiven elektrooptischen Bauelemente 121 bis 124 und 131 bis 134 können auch je nach Einsatzzweck Faseranschlüsse vorgesehen werden. Figur 6 zeigt ein Ausführungsbeispiel, bei welchem in der Eingangsseite die Laser durch Faseranschlüsse ersetzt sind. Auf gleiche Weise können auch die Empfangsdioden auf der Ausgangsseite durch Fasern ersetzt werden. Die Faser 22 liegt dabei in einer V-Nut 20, die durch anisotrope Ätzung so tief hergestellt wurde, daß der Faserkern und das aus der Faser austretende divergente Lichtbündel ganz unterhalb der Waferoberfläche bleibt. An der Stirnseite 21 der V-Nut 20 wird das Lichtbündel schräg nach unten in das Silizium hineingebrochen. Nach kurzer Entfernung trifft das Lichtbündel wieder auf eine Grenzfläche 8 einer Vertiefung 7, an der es totalreflektiert wird und nahezu senkrecht in das Substrat umgelenkt wird. Die weitere Strahlführung geschieht wie in Figur 1 beschrieben.

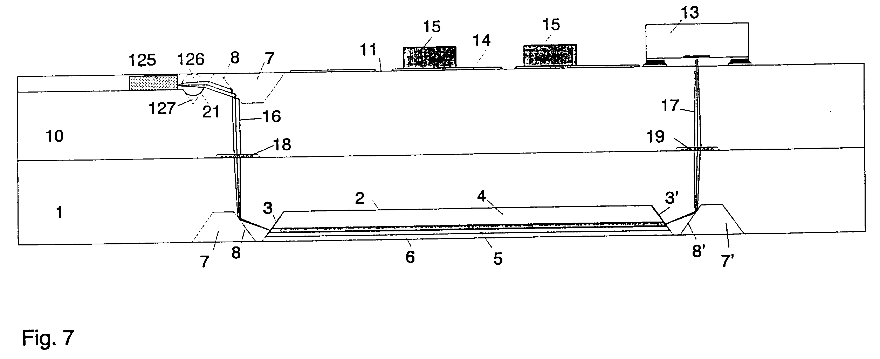

Anstelle der in Figur 1 gezeigten SELD-Laser lassen sich auch normale kantenemitierende Laser einsetzen. Figur 7 zeigt ein Ausführungsbeispiel mit einem kantenemittierenden Laser 125.

Hier ist eine Kollimierungsoptik 126 erforderlich, für die beispielsweise eine Kugellinse in einer anisotrop geätzten Vertiefung 127 verwendet werden kann. Die Strahlführung nach der Kollimierung ist wie in Figur 6 beschrieben.

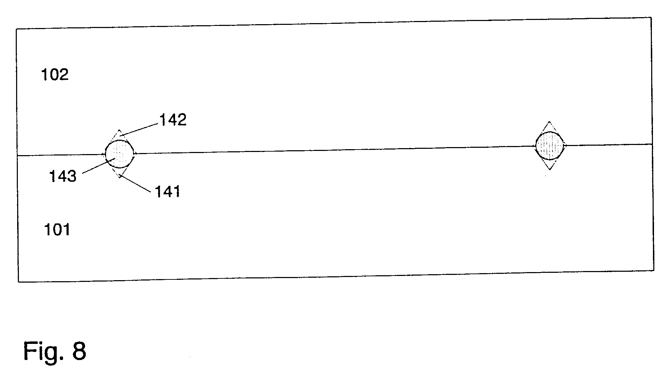

Zur exakten Positionierung der verschiedenen Substrate zueinander läßt sich ebenfalls die hochgenaue Strukturierung durch die anisotrope Ätztechnik verwenden. Hierfür werden zwei Möglichkeiten vorgeschlagen. Figur 8 zeigt eine Detailzeichnung eines Ausführungsbeispiels, bei welchem auf zwei zueinander zu justierenden Substraten 101 und 102 jeweils an korrespondierenden Stellen je eine pyramidenförmige Vertiefung 141 und 142 mit quadratischer Grundfläche anisotrop geätzt ist. In diese Vertiefungen wird eine Präzisionskugel 143 beispielsweise aus Glas oder Stahl eingelegt. Die Größe der beiden Vertiefungen wird so gewählt, daß die Kugel gerade die acht Seitenflächen der beiden Vertiefungen berührt wenn die Substratoberflächen miteinander in Kontakt sind. Zur Positionierung zweier Substrate zueinander sind mindestens 2 solcher Positionierhilfen an möglichst weit voneinander entfernten Stellen erforderlich.

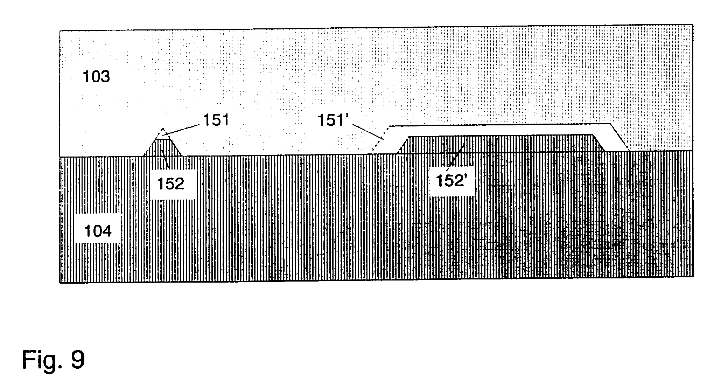

Eine weitere Möglichkeit zur Positionierung ist in Figur 9 gezeigt. Hier sind keine zusätzlichen Hilfskörper wie Kugeln erforderlich. In das eine Substrat 103 wird eine V-Nut 151 eingeätzt. Die Oberfläche des anderen Substrates 104 wird ganzflächig bis auf einen Steg 152 abgeätzt. Dieser Steg hat an seinen Enden konvexe Ecken, die während des Ätzens angegriffen werden, so daß der Steg 152 in seiner Länge an jedem Ende um etwa die Ätztiefe kürzer wird. Die Positionierung läßt sich an einem Steg mit dazugehöriger V-Nut nur in der Richtung senkrecht zur Stegrichtung erreichen. Zur Festlegung der Positionierung in der Stegrichtung ist daher ein zweiter Steg 152' mit V-Nut 151' benötigt, deren Richtung senkrecht zur ersten Positionierstruktur 151 und 152 verläuft.

Die Fixierung der verschiedenen Substrate eines Stapels aufeinander kann nach einem bekannten Verfahren durch Kleben oder anodisches Bonden geschehen.

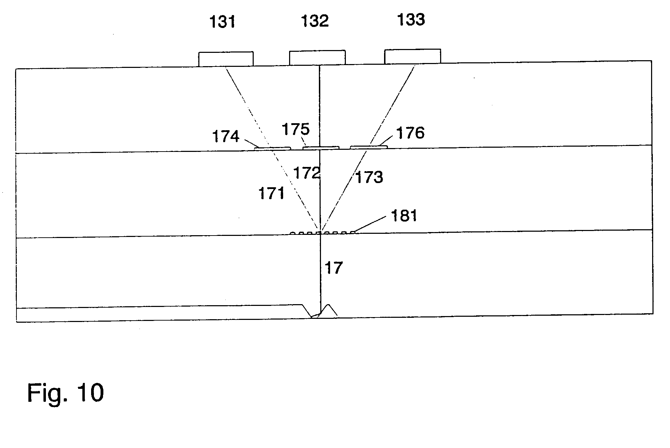

Neben den in Figur 1 gezeigten Fresnellinsen zur Lichtbündelung lassen sich auch Fresnellinsen zur Lichtstreuung 181 zwischen den einzelnen Substratebenen des Stapels einsetzen, wie in einem Ausführungsbeispiel in Figur 10 gezeigt ist. Auf diese Weise läßt sich das Licht aus der nahezu senkrechten Durchdringungsrichtung 17 in bestimmte vorgewählte Richtungen 171 bis 173 aufteilen und auf mehrere Kanäle verteilen. Bei Bedarf können durch flächenhafte elektrooptisch oder thermooptisch schaltbare Elemente, beispielsweise LCDs, 174 bis 176 zwischen den Ausgängen das Licht beliebig schalten.

**Patentansprüche**

1. Optische Vorrichtung mit mindestens einem lichtaussendenden Element (12) und mit mindestens einem lichtempfangenden Element (13), die so angeordnet sind, daß sie optisch miteinander gekoppelt sind, wobei die Vorrichtung die folgenden Merkmale aufweist:

   a) die lichtaussendenden und -empfangenden Elemente (12, 13) befinden sich auf der einer Grundfläche eines ersten lichtdurchlässigen Trägers (10) gegenüberliegenden Kehrseite (11) dieses Trägers,

   b) ein zweiter lichtdurchlässiger Träger (1) befindet sich auf dem ersten Träger (10), indem die Grundflächen beider Träger einander zugewandt sind, gegebenenfalls unter Dazwischenschaltung weiterer lichtdurchlässiger Träger,

   c) der zweite Träger (1) trägt auf der seiner Grundfläche gegenüberliegenden Kehrseite eine Lichtwellenleiterstruktur (5) und mindestens zwei Reflexionsflächen (8, 8'), die so angeordnet sind, daß ein Lichtbündel, das vom lichtaussendenden Element (12) ausgeht, die Grundflächen kreuzt, auf eine Reflexionsfläche (8) trifft, die Lichtwellenleiterstruktur (5) durchläuft, auf die zweite Reflexionsfläche (8') trifft, die Grundflächen nochmals kreuzt und am lichtempfangenden Element (13) endet,

   dadurch gekennzeichnet, daß zwischen den Grundflächen des ersten und des zweiten Trägers (1, 10) eine Linse, insbesondere eine Fresnellinse, als lichtdurchlässige Zwischenlage (18, 19) vorgesehen ist,

daß an mindestens einem Lichtwellenleiterende mehrere lichtaussendende und/oder -empfangende Elemente vorgesehen sind, daß Mittel zwischen Zwischenlage und diesen Elementen zur Aufteilung des Lichtbündels in mehrere Bündel, die vorbestimmte Richtungen (171, 172, 173) aufweisen vorgesehen sind, und

daß zwischen der Zwischenlage und diesen Elementen mindestens ein Element (174, 175, 176) vorgesehen ist, das zwischen den Zuständen "lichtdurchlässig" und "lichtundurchlässig" schaltbar ist.

2. Vorrichtung nach Patentanspruch 1, dadurch gekennzeichnet, daß die Reflexionsflächen (8,8') totalreflektierend sind.

3. Vorrichtung nach einem der Patentansprüche 1 oder 2, dadurch gekennzeichnet, daß die Lichtwellenleiterstruktur (5) ein Lichtwellenleiterabschnitt, insbesondere ein Faserabschnitt in einer V-Nut ist.

4. Vorrichtung nach einem der Patentansprüche 1 oder 2, dadurch gekennzeichnet, daß die Lichtwellenleiterstruktur (5) eine Verzweigerstruktur, ein Schalter oder eine Schaltmatrix mit Streifenwellenleitern ist.

5. Vorrichtung nach einem der Patentansprüche 1 oder 2, dadurch gekennzeichnet, daß die Lichtwellenleiterstruktur (5) ein Koppler, insbesondere ein Sternkoppler ist.

6. Vorrichtung nach einem der Patentansprüche 1 bis 5, dadurch gekennzeichnet, daß die Träger (1,10) verschiebbar aufeinander angeordnet sind.

7. Vorrichtung nach einem der Patentansprüche 1 bis 5, dadurch gekennzeichnet, daß die Träger (1,10) nach Justage miteinander fixiert sind, insbesondere durch Verkleben oder Bonden.

8. Vorrichtung nach einem der Patentansprüche 1 bis 5, dadurch gekennzeichnet, daß sich auf den Grundflächen der Träger (103,104) anisotrop geätzte komplementäre Strukturen (151,151',152,152') befinden, deren Flanken zur Auflage der Träger (103,104) aufeinander dienen.

9. Vorrichtung nach einem der Patentansprüche 1 bis 5, dadurch gekennzeichnet, daß sich auf den Grundflächen der Träger (101,102) anisotrop geätzte Strukturen (141,142) befinden, deren Flanken jeweils zur Auflage mindestens eines den beiden Trägern (101,102) gemeinsamen Hilfselementes (143) dienen.

**10.** Vorrichtung nach einem der Patentansprüche 1 bis 9, dadurch gekennzeichnet, daß mehrere lichtdurchlässige Träger (101 bis 104) vorgesehen sind, von denen mindestens einer mindestens zwei Reflexionsflachen und eine Lichtwellenleiterstruktur (51 bis 54) trägt.

**11.** Vorrichtung nach Patentanspruch 10, dadurch gekennzeichnet, daß auf mehreren lichtdurchlsssigen Trägern (101 bis 104) Lichtwellenleiterstrukturen (51,54) vorgesehen sind, wobei die Lichtwellenleiterenden der Lichtwellenleiterstrukturen auf den Trägern gegeneinander versetzt angeordnet sind derart, daß die Lichtbündel zu/von den jeweiligen Trägern nicht in Lichtwellenleiterstrukturen anderer Träger einstrahlen.

**12.** Vorrichtung nach einem der Patentansprüche 1 bis 11, dadurch gekennzeichnet, daß für jedes Lichtwellenleiterende eine Reflexionsfläche vorgesehen ist.

**13.** Vorrichtung nach einem der Patentansprüche 1 bis 12, dadurch gekennzeichnet, daß als lichtaussendende und/oder empfangende Elemente optoelektronische Sende- bzw. Empfangselemente vorgesehen sind.

**14.** Vorrichtung nach einem der Patentansprüche 1 bis 13, dadurch gekennzeichnet, daß als lichtaussendende und/oder empfangende Elemente Lichtwellenleiterenden vorgesehen sind.

**15.** Vorrichtung nach Anspruch 2, dadurch gekennzeichnet,

- daß der zweite Träger (1) ein Siliziumträger ist, dessen (100)-Ebene in der Waverebene liegt und der auf seiner Kehrseite eine anisotrop geätzte Vertiefung (2) mit einem Wellenleiter (5) aufweist,
- daß Lichtbündel an den Grenzflächen (3, 3') an den Wellenleiterenden in den Siliziumträger hinein gebrochen werden und auf die Reflexionsflächen (8, 8') treffen, die durch Böschungsflächen weiterer anisotrop geätzter Vertiefungen (7, 7') gebildet sind,
- daß die Lichtbündel nach Totalreflexion an den Reflexionsflächen nahezu senkrecht zu den Grundflächen der Träger (1, 10) verlaufen.

**Claims**

**1.** Optical device having at least one light-emitting element (12) and having at least one light-receiving element (13) which are arranged in such a way that they are coupled optically to one another, the device having the following features;

a) the light-emitting and light-receiving elements (12, 13) are located on that reverse side (11) of a first light-transmitting carrier (10), which lies opposite a base face,

b) a second light-transmitting carrier (1) is located on the first carrier (10) by virtue of the fact that the base faces of the two carriers are facing one another, possibly with interposition of further light-transmitting carriers,

c) the second carrier (1) has, on that reverse side lying opposite its base face, an optical wave guide structure (5) and at least two reflective faces (8, 8') which are arranged in such a way that a light beam which starts from the light-emitting element (12) crosses the base faces, strikes a reflective face (8), passes through the optical wave guide structure (5), strikes the second reflective face (8'), crosses the base faces once more and ends at the light-receiving element (13),

characterized in that a lens, in particular a Fresnel lens is provided as a light-transmitting intermediate layer (18, 19) between the base faces of the first and second carriers (1, 10), in that a plurality of light-emitting and/or light-receiving elements are provided at at least one end of the optical waveguide, and in that means are provided between the intermediate layer and these elements in order to split up the light beam into a plurality of beams which have predetermined directions (171, 172, 173), and in that between the intermediate layer and these elements at least one element (174, 175, 176) is provided which can be switched between the "light-transmitting" and "light-nontransmitting" states.

**2.** Device according to Claim 1, characterized in that the reflective faces (8, 8') are totally reflecting.

**3.** Device according to one of Patent Claims 1 or 2, characterized in that the optical waveguide structure (5) is a section of optical waveguide, in particular a section of fibre in a V groove.

**4.** Device according to one of Patent Claims 1 or 2, characterized in that the optical waveguide structure (5) is a junction structure, a switch or a switching matrix with the strip waveguides.

**5.** Device according to one of Patent Claims 1 or 2, characterized in that the optical waveguide structure (5) is a coupler, in particular a star coupler.

**6.** Device according to one of Patent Claims 1 to 5, characterized in that the carriers (1, 10) are arranged displaceably one on top of the other.

**7.** Device according to one of Patent Claims 1 to 5, characterized in that the carriers (1, 10) are secured to one another, in particular by gluing or bonding, after alignment.

**8.** Device according to one of Patent Claims 1 to 5, characterized in that anisotropically etched complementary structures (151, 151', 152, 152'), whose edges serve to support the carriers (103, 104) on top of one another, are located on the base faces of the carriers (103, 104).

**9.** Device according to one of Patent Claims 1 to 5, characterized in that anisotropically etched structures (141, 142), whose edges serve in each case to support at least one auxiliary element (143) which is common to the two carriers (101, 102), are located on the base faces of the carriers (101, 102).

**10.** Device according to one of Patent Claims 1 to 9, characterized in that a plurality of light-transmitting carriers (101 to 104) are provided, at least one of which has at least two reflective faces and one optical waveguide structure (51 to 54).

**11.** Device according to Patent Claim 10, characterized in that optical waveguide structures (51, 54) are provided on a plurality of light-transmitting carriers (101 to 104), the ends of the optical waveguides of the optical waveguide structures being arranged offset with respect to one another on the carriers in such a way that the light beams to/from the respective carriers are not incident into optical waveguide structures of other carriers.

**12.** Device according to one of Patent Claims 1 to 11, characterized in that a reflective face is provided for each end of the optical waveguide.

**13.** Device according to one of Patent Claims 1 to 12, characterized in that optoelectronic transmitting and/or receiving elements are provided as light-emitting and/or light receiving elements.

**14.** Device according to one of Patent Claims 1 to 13, characterized in that ends of optical waveguides are provided as light-emitting and/or light-receiving elements.

**15.** Device according to Claim 2, characterized

- in that the second carrier (1) is a silicon carrier the plane of which (100) is located in the Waver plane and which has, on its reverse side, an anisotropically etched depression (2) with an optical waveguide (5),
- in that light beams are refracted at the boundary faces (3, 3') at the ends of the optical waveguide into the silicon carrier and strike the reflective faces (8, 8') which are formed by sloping faces of further anisotropically etched depressions (7, 7'),

- in that after total reflection the light beams at the reflective faces run virtually perpendicularly with respect to the base faces of the carriers (1, 10).

**Revendications**

**1.** Dispositif optique comportant au moins un élément photoémetteur (12) et au moins un élément photorécepteur (13), ces éléments étant placés pour être couplés optiquement, avec les caractéristiques suivantes :

a) les éléments photoémetteurs et photorécepteurs (12, 13) se trouvent sur la face (11) de ce support non tournée vers la surface de base d'un premier support transparent à la lumière (10),
b) un second support transparent à la lumière (1) se trouve sur le premier support (10), les surfaces de base des deux supports étant tournées l'une vers l'autre, et le cas échéant avec interposition d'autres supports transparents à la lumière,
c) le second support porte sur sa face opposée à sa surface de base, une structure de guide de lumière (5) et au moins deux surfaces de réflexion (8, 8') disposées pour qu'un faisceau lumineux partant de l'élément photoémetteur (12) croise les surfaces de base, rencontre une surface réfléchissante (8), traverse la structure de guide de lumière (5), arrive sur une seconde surface réfléchissante (8'), croise de nouveau les surfaces de base et arrive finalement sur l'élément photosensible (13),
caractérisé par

- une lentille, notamment une lentille de Fresnel comme couche intermédiaire transparente à la lumière (18, 19), entre les surfaces de base du premier et du second support (1, 10),
- plusieurs éléments photoémetteurs et/ou photorécepteurs, sur au moins une extrémité de guide d'onde,
- des moyens prévus entre les couches intermédiaires et ces éléments pour répartir le faisceau de rayon dans plusieurs faisceaux qui ont des directions prédéterminées (171, 172, 173) et,
- au moins un élément (174, 175, 176) entre la couche intermédiaire et ces éléments qui peut commuter entre un état 《 transparent à la lumière 》 et un état 《opaque à la lumière》.

2. Dispositif selon la revendication 1,
   caractérisé en ce que
   les surfaces de réflexion (8, 8') sont à réflexion totale.

3. Dispositif selon l'une des revendications 1 ou 2,
   caractérisé en ce que
   la structure de guide de lumière (5) est un segment de guide de lumière, notamment un segment de fibres dans une rainure à section en V.

4. Dispositif selon l'une quelconque des revendications 1 ou 2,
   caractérisé en ce que
   la structure de guide de lumière (5) est une structure à dérivation, un commutateur ou une matrice de commutation avec des guides d'onde en bande.

5. Dispositif selon l'une quelconque des revendications 1 ou 2,
   caractérisé en ce que
   la structure de guide de lumière (5) est un coupleur, notamment un coupleur en étoile.

6. Dispositif selon l'une quelconque des revendications 1 à 5,
   caractérisé en ce que
   les supports (1, 10) sont disposés de manière coulissante l'un par-dessus l'autre.

7. Dispositif selon l'une quelconque des revendications 1 à 5,
   caractérisé en ce que
   les supports (1, 10) sont fixés entre eux par ajustage, notamment par collage ou liaison.

8. Dispositif selon l'une quelconque des revendications 1 à 5,
   caractérisé par
   des structures complémentaires (151, 151', 152, 152') à attaque chimique anisotrope et dont les flancs servent d'appui aux supports (103, 104) sur les surfaces de base des supports (103, 104).

9. Dispositif selon l'une quelconque des revendications 1 à 5,
   caractérisé par
   des structures (141, 142) réalisées par attaque chimique anisotrope sur les surfaces de base des supports (101, 102), et dont les flancs servent d'appui à au moins un élément auxiliaire (143) commun aux deux supports (101, 102).

10. Dispositif selon l'une quelconque des revendications 1 à 9,
    caractérisé par

plusieurs supports transparents à la lumière (101-104) dont au moins un, porte deux surfaces de réflexion et une structure de guide de lumière (51-54).

11. Dispositif selon la revendication 10,
    caractérisé par
    des structures de guide de lumière (51, 54) prévues sur plusieurs supports transparents à la lumière (101-104), les extrémités des structures de guide de lumière étant décalées les unes par rapport aux autres sur les supports de façon que les faisceaux lumineux allant vers différents supports ou en provenance de ceux-ci n'arrivent pas dans les structures de guide de lumière d'autres supports.

12. Dispositif selon l'une quelconque des revendications 1 à 11,
    caractérisé par
    une surface de réflexion pour chaque extrémité de guide de lumière.

13. Dispositif selon l'une quelconque des revendications 1 à 12,
    caractérisé en ce que
    l'extrémité d'émission de lumière et/ou les éléments de réception sont des éléments d'émission ou de réception optoélectroniques.

14. Dispositif selon l'une quelconque des revendications 1 à 13,
    caractérisé en ce que
    les éléments photoémetteurs et/ou photorécepteurs sont les extrémités de guide d'onde.

15. Dispositif selon la revendication 2,
    caractérisé en ce que

    - le second support (1) est un support au silicium dont le plan cristallographique (100) se situe dans le plan de l'onde et présente sur sa face arrière une cavité (2) réalisée par attaque chimique anisotrope, recevant un guide d'onde (5),
    - le faisceau lumineux est injecté dans les surfaces limites (3, 3') aux extrémités des guides d'onde dans le support au silicium et le faisceau rencontre les surfaces de réflexion (8, 8') formées par des surfaces de talus d'autres cavités (7, 7') réalisées par attaque chimique anisotrope,
    - le faisceau lumineux passe après réflexion totale sur des surfaces de réflexion, pratiquement perpendiculairement aux surfaces de base des supports (1, 10).

Fig. 1

Fig 2

Fig 3

EP 0 603 549 B1

121    122    123    124

16    101

4    51

16    102

4    52

16    103

4    53

16    104

4    54

Fig 4

Fig 5

EP 0 603 549 B1

Fig. 6

EP 0 603 549 B1

Fig. 7

Fig. 8

Fig. 9

Fig. 10